# EUROPEAN PATENT APPLICATION

(11) **EP 4 733 778 A1**
(43) Date of publication of application: **29.04.2026**
(21) Application number: 25209859.5
(22) Date of filing: 20.10.2025
(51) Int. Cl.: G01R 19/25, H02J 50/00, H04Q 9/00, G01R 15/14, G01R 15/18, G01R 31/58, H02J 13/13, H02J 50/10

(54) **MONITORING DEVICE MOUNTABLE ON AN ELECTRIC CABLE OF AN OVERHEAD POWER LINE, MONITORING SYSTEM OF AN OVERHEAD POWER LINE USING SUCH A MONITORING DEVICE AND METHOD FOR CONTROLLING SUCH A MONITORING DEVICE**

(30) Priority: 21.10.2024 IT 202400023343
(71) Applicant: Calzavara S.p.A., 00181 Roma (RM) (IT)
(72) Inventor: CALZAVARA, Marco, 33010 Pagnacco (UD) (IT); CALZAVARA, Massimo, 33100 Udine (UD) (IT)
(74) Representative: Frare, Paolo

(57) **Abstract**

The present finding relates to a monitoring device (5) mountable on an electric cable (2) of an overhead power line (3), a system (1) for monitoring an overhead power line (2) using such monitoring device (5), and a method for controlling such monitoring device (5).

## Description

The present finding relates to a monitoring device mountable on an electric cable of an overhead power line, a monitoring system of an overhead power line using such monitoring device, and a method for controlling such monitoring device.

Nowadays, for the distribution of electric energy, and in particular of alternating electric current, it is known to use overhead power lines in which electric cables are supported by dedicated pylons or poles at a desired distance from the ground.

Such overhead power lines can extend for very long distances (tens or hundreds of kilometres), and their electric cables can pass above buildings, trees, roads, railways, rivers, etc.

The large extension of such overhead power lines leads to the need to be able to remotely monitor both the electric cables (for example, to prevent or address damage that could be caused by strong mechanical stresses thereto, due for example to the presence of snow, ice, strong wind, etc., or to detect the temperature of such cables, which affects their deformation and therefore their proximity to the ground, etc.), the pylons or poles that support them (for example, to detect any deformations or damage that could compromise their duration or cause their breakage), and the space around the overhead power line itself (such as, for example, to detect in advance the presence of foreign bodies, such as for example trees, placed in the proximity to the cables, which could come into contact with them and create a short circuit or an electric discharge, or otherwise compromise the functionality of the overhead power line itself).

For the remote monitoring of overhead power lines, it is known to mount, astride one or more of their electric cables, corresponding monitoring devices, which are typically equipped with electromagnetic coupling generation means (typically a ferromagnetic core) capable of coupling by electromagnetic induction with the electromagnetic field generated by the cable and of generating an electric current to electrically power the monitoring device.

In some cases, such monitoring devices are equipped with rechargeable batteries, so as to be able to operate for a certain period of time even in the case where the current in the electric cable on which they are mounted is low or zero; such rechargeable batteries are recharged by the electric current generated by the electromagnetic coupling generation means when the cable is carrying an electric current.

Such monitoring devices further comprise detection means, such as for example gyroscopes, accelerometers, thermometers, GPS (global positioning system) type localization systems, etc., which detect temperature, position, movement conditions of the cable, etc.; such monitoring devices are powered by the electric current generated by the electromagnetic coupling generation means when the cable is carrying an electric current and/or by the rechargeable batteries, if present.

Such known-type monitoring devices further comprise a telecommunication device (for example, an electronic data transmission/reception board equipped with an antenna), which typically sends, in wireless (wire-free) mode, the information detected by the detection devices to a further dedicated telecommunication device (for example, an electronic data transmission/reception board equipped with an antenna), placed at a desired distance from the overhead power line, operatively connected to a device (for example, a computer) equipped with a user interface capable of communicating to a user (for example, the operator of the overhead power line) the information detected by the detection means; in this way, the user can remotely monitor the parameters of the overhead power line detected by the detection means, and promptly intervene if, on the basis of such parameters, a problem is detected or anticipated.

The detection of information performed by the detection devices and the transmission of such information through the telecommunication device require the availability of a relatively high amount of electric energy, which increases proportionally with the amount of data being detected and transmitted; such electric energy is provided by the cable of the overhead power line on which the monitoring device is mounted, through the electromagnetic coupling generation means of the latter, and possibly, if present, by the rechargeable batteries, which are in turn recharged using the energy drawn from the electric cable through the electromagnetic coupling generation means of the monitoring device.

Such known solutions, although presenting numerous advantages, still leave room for improvement.

Indeed, both due to the fact that the electric energy demand from end-users (for example, households, industrial facilities, sports facilities, etc.) to which the overhead power line provides energy is not exactly predictable, and as a result of possible discontinuous electric energy input into the overhead power line from the energy sources that power it (which occurs in particular in the case of renewable sources, such as for example photovoltaic panels and wind generators, whose production of electric energy depends on environmental conditions), it is possible that the monitoring device cannot have the necessary energy to power its detection devices and telecommunication device precisely when such devices are, respectively, performing detections or transmitting information, with the risk that the detections can result in incomplete or incorrect information and/or that the transmitted information can be in turn missing, incomplete, or incorrect.

Such drawback can occur even if the monitoring device is provided with rechargeable batteries, since the variability in electric energy trend described above does not ensure that such rechargeable batteries will be charged when using the detection and telecommunication devices of the monitoring device.

The main task of the present finding is to address the above-identified problems and thus to avoid, as far as possible, that a monitoring device suitable for detecting parameters associated with an electric cable of an overhead power line, on which such monitoring device is mounted, is unexpectedly left without electric power when detecting information associated with the overhead power line or during the transmission of such information outside such overhead power line.

Within such task, an object of the finding is to allow to use a monitoring device also equipped with detection means having high electric energy consumption (such as for example video-cameras), while reducing the risk that they can run out of electric power during detection operations.

Another object of the finding is to allow the transfer outside the overhead power line of information related thereto (such as for example images or videos), which require, for their transmission, a high amount of electric energy, while reducing the risk of being without electric power during transmission operations.

The above-mentioned task and purposes are achieved by a monitoring device of an overhead power line according to claim 1.

The above-mentioned task and purposes are also achieved by a monitoring system of an overhead power line according to claim 6.

The above-mentioned task and purposes are achieved by a method for controlling a monitoring device mounted on an overhead power line according to claim 9.

Other advantageous features of the finding are set forth in the dependent claims.

The features and advantages of the present finding will become more apparent from the following description, provided by way of example and not limitation, referred to the attached schematic drawings, in which:
- Figure 1 is a schematic view of a portion of an overhead power line with an advantageous example of a system according to the finding applied thereto;

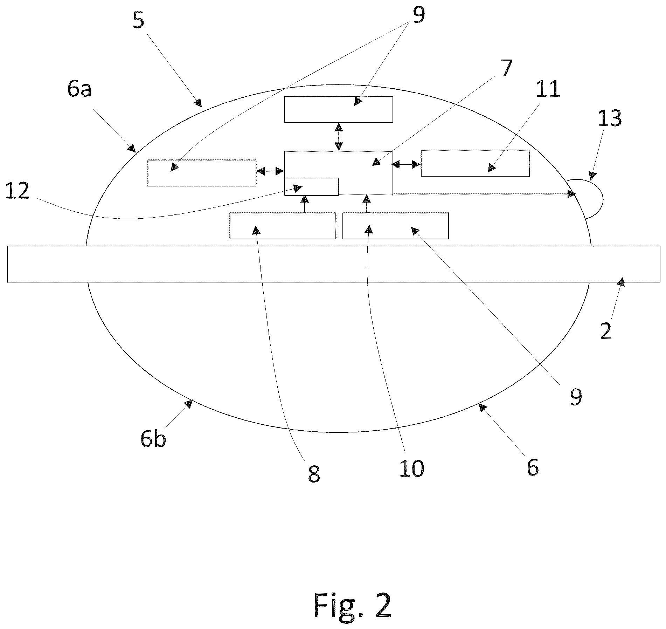

- Figure 2 is a schematic view of an advantageous example of a monitoring device according to the finding, applied to an electric cable of an overhead power line.

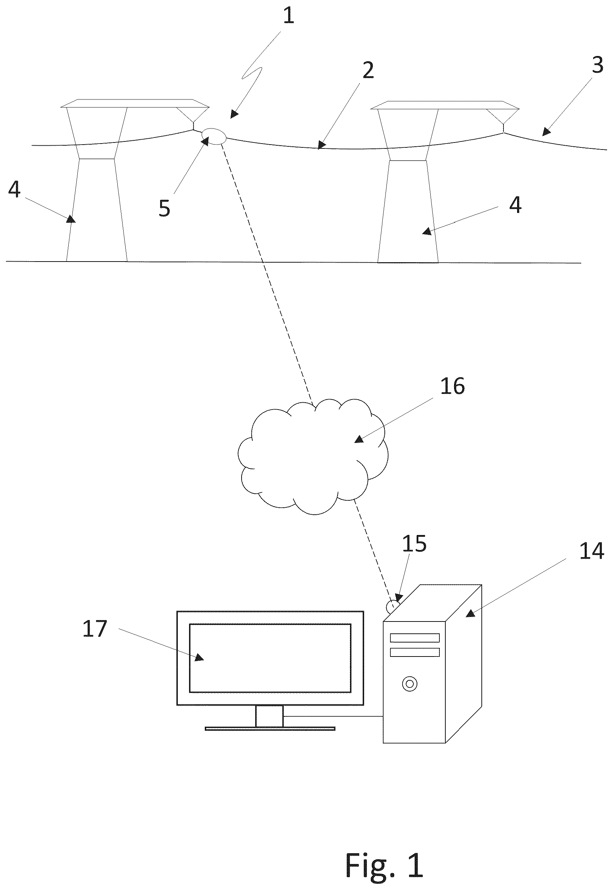

Figure 1 schematically depicts an advantageous embodiment of a system 1 according to the finding, applied to an electric cable 2 of an overhead power line 3 (only a short section of which is schematically depicted).

According to the finding, the system 1 can be applied to overhead power lines 3 equipped with a single electric cable 2 (so-called single-phase power lines, such as that schematically depicted in Figure 1), or to overhead power lines 3 with three electric cables 2 (so-called three-phase power lines, not depicted), or to overhead power lines 3 with any number of electric cables 2.

Advantageously, the electric cable 2 is supported by dedicated poles or pylons 4 of the power line 3, preferably fixed to the ground; the overhead power lines 3 are known in the field and will therefore not be described in further detail.

The system 1 according to the finding comprises a monitoring device 5, mountable on an electric cable 2 of an overhead power line 3.

Advantageously, the monitoring device 5 comprises a housing 6, preferably made of plastic and/or non-magnetic metallic material, such as aluminium, preferably die-cast aluminium; the housing 6 preferably comprises two half-shells 6a and 6b that can be fixed together in such a way as to clamp an electric cable 2 of an overhead power line 3 like a vice 3.

The housing 6 can also have other shapes and can possibly be fixed to the electric cable 2 by means of desired known fixing means, not illustrated, such as for example bolts, clamps, etc.

The monitoring device 5 comprises electronic control means 7 configured to control said monitoring device 5 (and in particular its various electric and electronic components); advantageously, such electronic control means 7 can be or comprise an electronic board, a microcontroller, a microprocessor, etc.

It is emphasized that, in the present text, stating that the electronic control means 7 are configured to *control* the monitoring device 5 means that such control means 7 are capable of commanding the various electric and electronic devices of the monitoring device 5 (if such devices are provided with the capability to be commanded) and/or of receiving and/or sending information (for example, regarding power-on status, measured or detected values, etc.) from/to such electric and electronic devices.

Advantageously, the electronic control means 7 are contained, at least partially, in the housing 6.

The monitoring device 5 further comprises electromagnetic coupling generation means 8 suitable for coupling by electromagnetic induction with the electromagnetic field generated by an electric cable 2, carrying an alternating electric current, of an overhead power line 3 on which the monitoring device 5 is mounted, and for generating an electric current to electrically power such monitoring device 5.

It is emphasized that the expression *"electrically power such monitoring device"* means providing the various electric and electronic components of said monitoring device 5 with the electric power (in the form of electric current and/or electric voltage) necessary for their operation.

Advantageously, the electromagnetic coupling generation means can be electrically connected to the various electric and electronic components they power, directly or with the interposition of possible additional electric or electronic components, not illustrated, such as for example static transformers, rectifiers, inverters, etc., suitable, for example, for modifying the current generated by the electromagnetic coupling generation means.

Such possible additional electric or electronic components are known in the field and will therefore not be described in further detail anymore.

Advantageously, such electromagnetic coupling generation means 8 are or comprise a solenoid, not illustrated, preferably wound around a ferromagnetic core, suitable for electromagnetically coupling with the electromagnetic field generated by an electric cable 2 on which the monitoring device 5 according to the finding is mounted, when an alternating electric current flows in such electric cable 2, thus generating in such solenoid, by effect of electromagnetic induction, an alternating current, which is then directed, possibly after being appropriately modified (for example, reduced in intensity and/or rectified) to the various electric and electronic components of the monitoring device 5; electromagnetic coupling generation means 8 of this type are known in the field and will therefore not be described in further detail anymore.

Advantageously, the electromagnetic coupling generation means 8 are contained, at least partially, in the housing 6.

The monitoring device 5 further comprises detection means 9, suitable for detecting one or more pieces of information associated with an overhead power line 3 on which the monitoring device 5 is mounted.

According to the finding, the electromagnetic coupling generation means 8 are electrically connected, directly or through possible additional electric or electronic components, to the detection means 9, so as to be able to electrically power them.

According to the finding, the electronic control means 7 are operatively connected to the detection means 9, so as to be able to control them.

It is emphasized that, in the present text, the expression *"information associated with an overhead power line"* includes various types of information that can be significant for the operation and/or management of the overhead power line 3; such information can comprise, for example, the values of electric parameters of the overhead power line 3 (for example the electric current passing through one of its electric cables 2 at a given moment, the electric voltage at which such electric cable 2 is at a given moment, the electric power being transported by the electric cable 2 at a given moment, etc.), information related to mechanical, thermal, spatial positioning, or visual parameters of the overhead power line 3 (for example the value of mechanical tension acting on one of its electric cables 2, the oscillations experienced by such electric cable 2, positional changes of said electric cable 2 with respect to a reference position, the temperature of the electric cable 2, images of the poles or pylons 4 to highlight possible damage thereof, etc.); information related to the external environment in which the power line 3 is positioned (for example the value of the humidity or air temperature around one of its electric cables 2, images related to foreign bodies with respect to the overhead power line 3, such as for example trees or buildings placed in the proximity to an electric cable 2, etc.).

Such detection means 9 can comprise, for example, an electric power detector and/or an electric current detector and/or an accelerometer and/or a magnetometer and/or a gyroscope and/or a temperature sensor and/or a humidity sensor and/or a video camera and/or a microphone.

Advantageously, the detection means 9 are contained, at least partially, in the housing 6.

According to the finding, the detection means 9 comprise acquisition means 10 of the instantaneous value of a quantity associated with the electric current flowing at a given moment in an electric cable 2 of an overhead power line 3 on which the monitoring device 5 is mounted.

Such acquisition means 10 can comprise, for example, a measure device of the inductive coupling type, such as for example a so-called amperometric transformer (commonly referred to as AT); such inductive coupling measure devices are known in the field and will therefore not be described in detail.

The monitoring device 5 further comprises first telecommunication means 11 configured to exchange information with the outside of the monitoring device 5; such first telecommunication means 11 can comprise, for example, an electronic data transmission/reception board, provided for example with an antenna (not shown), a wireless modem, etc.

Advantageously, the first telecommunication means 11 are contained, at least partially, in the housing 6.

According to the finding, the electromagnetic coupling generation means 8 are electrically connected, directly or through possible additional electric or electronic components, to the telecommunication means 11, so as to be able to electrically power them.

According to the finding, the electronic control means 7 are operatively connected to the telecommunication means 11, so as to be able to control them.

In advantageous embodiments, such as for example that illustrated in the attached figures, the monitoring device 5 comprises electrical energy storage means 12 configured to electrically power the monitoring device 5 and to be electrically charged by the electric current generated by such electromagnetic coupling generation means 8.

Advantageously, the electrical energy storage means 12 comprise one or more supercapacitors and/or one or more rechargeable batteries.

Advantageously, the electrical energy storage means 12 are contained, at least partially, in the housing 6.

Advantageously, the electronic control means 7 are operatively connected to the electrical energy storage means 12 and are configured to (for example, programmed to) detect (for example, measure, calculate, or receive related information from the electrical energy storage means 12) the charge status of said electrical energy storage means 12.

In advantageous embodiments, the monitoring device 5 comprises signalling means 13, for example a siren, a warning light, a speaker, etc., controlled by the electronic control means 7.

Other features of the monitoring device 5 according to the finding will be described below.

The system 1 for monitoring an overhead power line 3, according to the finding, further comprises a processing system 14, external to the monitoring device 5 and equipped with second telecommunication means 15 (for example an electronic data transmission/reception board provided, for example, with an antenna, a wireless modem, etc.), schematically illustrated in Figure 1, configured to exchange information, directly or with the interposition of a data transmission network 16 (for example the Internet or a dedicated transmission network), with the first telecommunication means 11 of the monitoring device 5.

In advantageous embodiments, the processing system 14 comprises a computer, for example a server, preferably equipped with user interface means 17, such as for example a monitor, for example of the touch screen type.

It is emphasized that, in advantageous embodiments, the monitoring device 5 can also be used not integrated in the system 1 according to the finding; in this case, the first telecommunication means 11 of the monitoring device 5 can be advantageously configured to send information associated with an overhead power line 3 on which the monitoring device 5 is mounted to a receiving device, not illustrated, operatively connected to a processing device, not illustrated, such as for example a computer, equipped with processing means and a user interface capable of communicating the received information to a user, possibly after processing it.

According to the finding, the electronic control means 7 of the monitoring device 5 are configured to control the detection means 9 and/or the first telecommunication means 11 based on the instantaneous value of a quantity associated with the electric current flowing at a given moment in an electric cable 2 of an overhead power line 3 on which the monitoring device 5 is mounted, as acquired by the acquisition means 10, also as a function of historical information related to previous values of a quantity associated with the electric current flowing in said electric cable 2, and also as a function of data on the electric consumption (for example, the current or electric power absorbed) of one or more components of the monitoring device 5, such data being preset or measured by the detection means 9.

It is emphasized that, in the present text, the expression *"a quantity associated with the electric current flowing at a given moment in an electric cable 2 of an overhead power line 3 on which the monitoring device 5 is mounted"* can mean, for example, the module (or intensity) of such electric current at a given moment, or to a quantity derivable (for example, through a suitable mathematical operation, performed for example by the electronic control means 7) from the value of the module of such electric current (and possibly from known parameters of the electric cable 2, such as for example length, section, electric resistivity of the material it is made of, etc.), such as for example the electric voltage at which the electric cable 2 is or the electric power passing through it at a given moment.

It is emphasized that, in the present text, the expression *"historical information related to previous values of a quantity associated with the electric current flowing in said electric cable"* indicates information that represents or depends on the previous trend of a quantity derivable (for example, the value of the quantity itself or a value related to such quantity by a suitable mathematical operation) from the value of said electric current (and possibly also from known parameters of the electric cable 2, such as length, section, the material it is made of, etc.), such as for example the module (or intensity) of such electric current itself, or the electric voltage at which the electric cable 2 is, or the electric power passing through it at a given moment; such historical information can be values related to past moments (for example, the values that such quantities assumed at a given time, the average value during the current year of the current at a certain hour of the day, etc.) or forecasts relating to future moments obtained, for example, by statistical algorithms and/or by an appropriately trained artificial intelligence system which, on the basis of the previous values of a certain quantity (for example, electric current or electric power), estimates the value that such quantity will assume at a given future moment.

Advantageously, the electronic control means 7 of the monitoring device 5 can be configured to control the detection means 9 and/or the first telecommunication means 11 in such a way that these operate only when they have and are about to have available an electric power, provided by the electric cable 2 on which the monitoring device 5 is mounted and possibly, if present, by the electrical energy storage means 12, sufficient to power the detection means 9 and/or the first telecommunication means 11 for the entire time required to perform their respective functions (or the detection of one or more pieces of information associated with an overhead power line 3 on which the monitoring device 5 is mounted and the exchange of such information with the outside of the monitoring device 5).

For example, as a function of the fact that, historically, on a certain day of the year, at a certain time, the power available in the electric cable 2 on which the monitoring device 5 is mounted exceeds a desired threshold, on the fact that the module of the power acquired by the acquisition means 10 at that moment is actually higher than a desired value, and on the fact that the electric consumption of one or more specific components of the monitoring device 5 (for example, a camera, not illustrated, and/or the first telecommunication means 11) is below a desired threshold, the electronic control means 7 can advantageously activate such camera to acquire an image of the electric cable 2 and/or its surroundings, and the first telecommunication means 11 can transmit to a remote device (for example, to the second telecommunication means 15 of the processing system 14) such image (or information related to such image), reducing the risk of unexpected energy drops that could compromise the acquisition and/or transmission of the information.

Conversely, if, on the basis of the historical information, it is predicted that, on a certain day of the year, at a certain time, the power available in the electric cable 2 on which the monitoring device 5 is mounted will be lower than a desired threshold, and also the module of the power acquired by the acquisition means 10 at that moment is actually lower than a desired value, and the electric consumption of one or more specific components of the monitoring device 5 (for example, a camera, not illustrated, and/or the first telecommunication means 11) is higher than a desired threshold, then the electronic control means 7 can advantageously inhibit the use of such camera and/or the first telecommunication means 11, so as to reduce the risk of energy drops when using the camera and/or when transmitting information that could compromise the acquisition and/or transmission of such information.

In advantageous embodiments, wherein the monitoring device 5 also comprises the electrical energy storage means 12, and wherein the electronic control means 7 are operatively connected to the electrical energy storage means 12 and are configured to detect the charge status of such electrical energy storage means 12, the electronic control means 7 can be advantageously configured to control the detection means 9 also as a function of the charge status of the electrical energy storage means 12.

For example, if, on the basis of the historical information, it is predicted that, on a certain day of the year, at a certain time, the power available in the electric cable 2 on which the monitoring device 5 is mounted will be lower than a desired threshold, the module of the power acquired by the acquisition means 10 at that moment is also lower than a desired value, and the electric consumption of one or more specific components of the monitoring device 5 (for example, a camera, not illustrated, and/or the first telecommunication means 11) is higher than a desired threshold, but the charge status of the electrical energy storage means 12 is above a desired threshold (advantageously such that the one or more specific components of the monitoring device 5 that are to be activated can draw all the necessary electric energy from the electrical energy storage means 12), then the electronic control means 7 can advantageously activate such specific components (for example, a camera to acquire an image of the electric cable 2 and/or its surroundings and the first telecommunication means 11) of the monitoring device 5.

In advantageous embodiments, the electronic control means 7 are configured to:
- store historical information related to previous values of a quantity associated with the electric current flowing in an electric cable 2 of an overhead power line 3 on which the monitoring device 5 is mounted;
- estimate, on the basis of such historical information, the expected value, at a given moment, of a quantity associated with the electric current flowing in said overhead power line 3;
- control the detection means 9 and/or the first telecommunication means 11 as a function of such expected value and on the instantaneous value of a quantity associated with the electric current flowing at a given moment in an electric cable 2 of an overhead power line 3 on which the monitoring device 5 is mounted, acquired by the acquisition means 10 of the latter.

In advantageous embodiments, such as for example that illustrated in Figure 1, the processing system 14 is configured to:
- receive, through the second telecommunication means 15, instantaneous data transmitted by the monitoring device 5 through the first telecommunication means 11, relating to the instantaneous value of a quantity associated with the electric current flowing at a given moment in an electric cable 2 of an overhead power line 3 on which the monitoring device 5 is mounted;
- process the instantaneous data received from the monitoring device 5, historical information related to previous values of a quantity associated with the electric current flowing in the electric cable 2, and data on the electric consumption of one or more components of the monitoring device 5, preset or received from the monitoring device 5;
- generate, as a function of the instantaneous data received, the historical information, and data on the electric consumption of one or more components of the monitoring device 5, instructions to control the electronic control means 7 of the monitoring device 5 in such a way that the electronic control means 7 control the detection means 9 and/or the first telecommunication means 11 as a function of the received data, the historical information processed by the processing system 14, and data on the electric consumption of one or more components of the monitoring device 5;
- transmit such instructions to the electronic control means 7 through the first telecommunication means 11 and the second telecommunication means 15, optionally with the interposition of a data transmission network 16.

In advantageous embodiments, wherein the monitoring device 5 also comprises the electrical energy storage means 12, and wherein the electronic control means 7 are operatively connected to the electrical energy storage means 12 and are configured to detect the charge status of said electrical energy storage means 12, the processing system 14 can be configured to generate the above-mentioned instructions also as a function of the charge status of the electrical energy storage means 12; advantageously, the information related to the charge status of said electrical energy storage means 12 can be transmitted from the first telecommunication means 11 of the monitoring device 5 to the second telecommunication means 15 of the processing system 14, directly or with the interposition of a data transmission network 16 (for example the Internet, or a dedicated transmission network).

In advantageous embodiments, the processing system 14 is configured to store historical information related to previous values of a quantity associated with the electric current flowing in an electric cable 2 of an overhead power line 3 on which the monitoring device 5 is mounted, and to estimate, on the basis of such historical information, the value at a given moment of a quantity associated with the electric current flowing in said overhead power line 3.

Such estimation can be performed, for example, by means of a common statistical algorithm, or by means of an artificial intelligence system, contained in or operatively connected to the processing system 14.

The method for controlling the monitoring device 5 according to the finding will be described hereinafter.

It is emphasized that, unless otherwise specified, such method can be used both in the case where the monitoring device 5 is part of a system 1 according to the finding, and in the case where such monitoring device 5 is used independently of the system 1, advantageously in combination with a processing device, not illustrated, such as for example a computer operatively connected thereto and equipped with processing means and a user interface capable of communicating to a user, possibly after processing it, the information received from the monitoring device 5.

The method for controlling the monitoring device 5 therefore comprises a step a) of acquiring (for example, measuring or calculating, on the basis of measured data for example the module of the current, and of any mathematical calculations performed using the result of such measure and possible known parameters related, for example, to the electric cable 2, such as for example section, length, and electric resistivity of the material of which it is made), by means of the acquisition means 10 of such monitoring device 5, the instantaneous value of a quantity (for example, the current itself, or the electric power flowing in the electric cable 2, or the electric voltage of the electric cable 2) associated with the electric current flowing at a given moment in the electric cable 2.

The method then comprises step b) of controlling, by the electronic control means 7, the detection means 9 and/or the first telecommunication means 11 as a function of such instantaneous value, historical information related to previous values of a quantity associated with the electric current flowing in the electric cable 2, and data on the electric consumption of one or more components of the monitoring device 5, preset or measured by the detection means 9.

Advantageously, the electronic control means 7 of the monitoring device 5 control the detection means 9 and/or the first telecommunication means 11 in such a way that they operate only when they have and are about to have available an electric power, provided by the electric cable 2 on which the monitoring device 5 is mounted, and possibly, if present, by the electrical energy storage means 12, sufficient to fully perform their functions of data detection or transmission, respectively.

Advantageously, the historical information related to previous values of a quantity associated with the electric current flowing in the electric cable 2 can be stored in or processed by the electronic control means 7, for example by means of dedicated algorithms, for example statistical algorithms, or by means of an artificial intelligence system.

In advantageous embodiments, in which the monitoring device 5 also comprises the electrical energy storage means 12, and in which the electronic control means 7 are operatively connected to the electrical energy storage means 12 and are configured to detect the charge status of such electrical energy storage means 12, the electronic control means 7 can advantageously be configured to control the detection means 9 also as a function of the charge status of the electrical energy storage means 12.

In advantageous embodiments, such as for example that illustrated in Figure 1, in which the monitoring device 5 is part of a system 1 according to the finding, the historical information related to previous values of a quantity associated with the electric current flowing in the electric cable 2 can be stored in or processed by the electronic control means 7 or, alternatively, stored in the processing system 14 or processed thereby, for example by means of appropriate algorithms, for example statistical algorithms, or by means of an artificial intelligence system.

In advantageous embodiments, such as for example that illustrated in Figure 1, in which the monitoring device 5 is part of a system 1 according to the finding, the method can advantageously comprise, after step a) and before step b), the following steps, in the following order:
step a1): transmitting, from the monitoring device 5 to the processing system 14, by means of the first telecommunication means 11 and the second telecommunication means 15, with the possible interposition of a data transmission network 16, instantaneous data relating to the instantaneous value of the quantity associated with the electric current flowing at a given moment in the electric cable 2, as acquired by the acquisition means 10;
step a2): processing, by means of the processing system 14, the instantaneous data received from the monitoring device 5, the historical information related to previous values of a quantity associated with the electric current flowing in the electric cable 2, and data on the electric consumption of one or more components of the monitoring device 5, preset or received from the monitoring device 5;
step a3): generating, as a function of the received instantaneous data, the historical information and data on the electric consumption of one or more components of the monitoring device 5, instructions to control the electronic control means 7 of the monitoring device 5 in such a way that the electronic control means 7 control the detection means 9 and/or the first telecommunication means 11 as a function of the received instantaneous data, the historical information processed by the processing system 14 and data on the electric consumption of one or more components of the monitoring device 5;
step a4): transmitting such instructions to the electronic control means 7 through the first telecommunication means 11 and the second telecommunication means 15, with the possible interposition of a data transmission network 16.

From the above description, the features and advantages of the finding are clearly apparent.

Indeed, due to the fact that the detection means and/or the first telecommunication means are controlled as a function of the instantaneous value of a quantity associated with the electric current flowing at a given moment in an electric cable of an overhead power line on which the monitoring device is mounted, as acquired by the acquisition means of the monitoring device, on historical information related to previous values of a quantity associated with the electric current flowing in said electric cable, and of data on the the electric consumption of one or more components of the monitoring device, the risk that the monitoring device is unexpectedly left without electric power when detecting information associated with the overhead power line or when transmitting such information to the outside of such overhead power line is extremely reduced.

Furthermore, due to such control of the detection means and/or the first telecommunication means, it is possible to use in the monitoring device also detection means having high electric energy consumption (such as for example video-cameras which, when operating on images, handle a very large amount of data, resulting in a very high energy consumption both for acquiring and transmitting them), while reducing the risk that they can run out of electric power during detection and transmission operations.

It is finally clear that the device, the system, and the method according to the finding are susceptible to numerous modifications and variants, all falling within the finding; furthermore, all the details are replaceable by technically equivalent elements without departing from the scope of the attached claims.

## Claims

1. Monitoring device (5) mountable on an electric cable (2) of an overhead power line (3), comprising:
- electronic control means (7) configured to control said monitoring device (5);
- electromagnetic coupling generation means (8) suitable for coupling by electromagnetic induction with the electromagnetic field generated by an electric cable (2), carrying an alternating electric current, of an overhead power line (3) on which said monitoring device (5) is mounted and for generating an electric current to electrically power said monitoring device (5);
- detection means (9), suitable for detecting one or more pieces of information associated with an overhead power line (3) on which said monitoring device (5) is mounted, comprising acquisition means (10) of the instantaneous value of a quantity associated with the electric current flowing at a given moment in an electric cable (2) of an overhead power line (3) on which said monitoring device (5) is mounted;
- first telecommunication means (11) configured to exchange information with the outside of said monitoring device (5);
which is **characterised in that**
said electronic control means (7) are configured to control said detection means (9) and/or said first telecommunication means (11) as a function of the instantaneous value of a quantity associated with the electric current circulating at a given moment in an electric cable (2) of an overhead power line (3) on which said monitoring device (5) is mounted, acquired by said acquisition means (10), of historical information related to previous values of a quantity associated with the electric current circulating in said electric cable (2) and of data on the electric consumption of one or more components of said monitoring device (5), said data being preset or measured by said detection means (9).

2. Monitoring device (5), as in claim 1, comprising electrical energy storage means (12) configured to be able to electrically power said monitoring device (5) and to be able to be electrically charged by said electric current generated by said electromagnetic coupling generation means (8), wherein said electronic control means (7) are configured to control said detection means (9) also as a function of the charge status of said electrical energy storage means (12).

3. Monitoring device (5), as in claim 1 or 2, wherein said detection means (9) comprise an electric power detector and/or an electric current detector and/or an accelerometer and/or a magnetometer and/or a gyroscope and/or a temperature sensor and/or a humidity sensor and/or a video camera and/or a microphone.

4. Monitoring device (5), as in claim 1 or 2 or 3, wherein said electrical energy storage means (12) comprise one or more supercapacitors and/or one or more rechargeable batteries.

5. Monitoring device (5), as in a preceding claim, wherein said electronic control means (7) are configured to:
- store historical information related to previous values of a quantity related to the electric current circulating in an electric cable (2) of an overhead power line (3) on which said monitoring device (5) is mounted;
- estimate, on the basis of said historical information, the expected value, at a given instant, of a quantity associated with the electric current circulating in said electric cable (2);
- control said detection means (9) and/or said first telecommunication means (11) as a function of said expected value, of said instantaneous value of a quantity associated with the electric current flowing at a given instant in an electric cable (2) of an overhead power line (3) on which said monitoring device (5) is mounted, acquired by said acquisition means (10) and of said data on the electric consumption of one or more components of said monitoring device (5).

6. System (1) for monitoring an overhead power line (3) comprising:
- a monitoring device (5) as in one or more of the preceding claims;
- a processing system (14) external to said monitoring device (5) and equipped with second telecommunication means (15) configured to exchange information, directly or with the interposition of a data transmission network (16), with said first telecommunication means (11);
which is **characterised in that**
said processing system (14) is configured to:
- receive, through said second telecommunication means (15), instantaneous data transmitted by said monitoring device (5) through said first telecommunication means (11), relating to the instantaneous value of a quantity associated with the electric current circulating at a given moment in an electric cable (2) of an overhead power line (3) on which said monitoring device (5) is mounted;
- process said instantaneous data received from said monitoring device (5), historical information related to previous values of a quantity associated with the electric current flowing in said electric cable (2) and data on the electric consumption of one or more components of said monitoring device (5), preset or received from said monitoring device (5);
- generate, as a function of said instantaneous data received, said historical information and said data on the electric consumption of one or more components of said monitoring device (5), instructions for controlling said electronic control means (7) of said monitoring device (5) in such a way that said electronic control means (7) control said detection means (9) and/or said first telecommunication means (11) as a function of said instantaneous data received, said historical information processed by said processing system (14) and said data on the electric consumption of one or more components of said monitoring device (5);
- transmit said instructions to said electronic control means (7) through said first telecommunication means (11) and said second telecommunication means (15), with the possible interposition of a data transmission network (16).

7. System (1), as in claim 6, comprising a monitoring device as in claim 2 or a claim dependent on claim 2, wherein said processing system (14) is configured to generate said instructions also as a function of the charge status of said electric energy storage means (12).

8. System (1), as in claim 6 or 7, wherein said processing system (14) is configured to store historical information related to previous values of a quantity related to the electric current circulating in an electric cable (2) of an overhead power line (3) on which said monitoring device (5) is mounted and to estimate, on the basis of said historical information, the value at a given moment of a quantity associated with the electric current circulating in said overhead power line (3).

9. Method for controlling a monitoring device (5) mounted on an electric cable (2) of an overhead power line (3), as in one of claims 1 to 5, comprising the following steps:
a) acquiring, by means of said acquisition means (10) of said monitoring device (5), the instantaneous value of a quantity associated with the electric current circulating at a given moment in said electric cable (2);
b) controlling, by means of said electronic control means (7), said detection means (9) and/or said first telecommunication means (11) as a function of said instantaneous value, of historical information related to previous values of a quantity associated with the electric current circulating in said electric cable (2) of said overhead power line (3), stored in said electronic control means (7) and/or in a processing system (14) external to said monitoring device (5) and equipped with second telecommunication means (15) configured to exchange information, directly or with the interposition of a data transmission network (16), with said first telecommunication means (11) of said monitoring device (5), and of data on the electric consumption of one or more components of said monitoring device (5), preset or measured by said detection means (9).

10. Method, as in claim 9, comprising a monitoring device as in claim 2 or in a claim dependent on claim 2, wherein said electronic control means (7) control said detection means and/or said first telecommunication means (11) also as a function of the charge status of said electrical energy storage means (12).

11. Method, as in claim 9 or 10, wherein said monitoring device (5) is part of a system (1) as in one or more of claims 6 to 8, comprising, after said step a) and before said step b), the following steps, in the following order:
a1) transmitting from said monitoring device (5) to said processing system (14), by means of said first telecommunication means (11) and of said second telecommunication means (15), with the possible interposition of a data transmission network (16), instantaneous data relating to said instantaneous value of said quantity associated with the electric current circulating at a given moment in said electric cable (2), acquired by said acquisition means (10);
a2) processing, by means of said processing system (14), said instantaneous data received from said monitoring device (5), historical information related to previous values of a quantity associated with the electric current flowing in said electric cable (2) and data on the electric consumption of one or more components of said monitoring device (5), preset or received from said monitoring device (5);
a3) generating, as a function of said instantaneous data received, of said historical information and of data on the electric consumption of one or more components of said monitoring device (5), instructions for controlling said electronic control means (7) of said monitoring device (5) in such a way that said electronic control means (7) control said detection means (9) and/or said first telecommunication means (11) as a function of said instantaneous data received, of said historical information processed by said processing system (14) and of said data on the electric consumption of one or more components of said monitoring device (5);
a4) transmitting said instructions to said electronic control means (7) through said first telecommunication means (11) and said second telecommunication means (15), with the possible interposition of a data transmission network (16).
